# EUROPEAN PATENT SPECIFICATION

(11) **EP 4 385 788 B1**
(45) Date of publication and mention of the grant of the patent: **30.09.2026**
(21) Application number: 23202848.0
(22) Date of filing: 10.10.2023
(51) Int. Cl.: B60L 3/00, H01H 47/00, B60L 58/10

(54) **SWITCH CONTROL DEVICE AND BATTERY PACK INCLUDING THE SAME**
SCHALTSTEUERUNGSVORRICHTUNG UND BATTERIEPACK DAMIT
DISPOSITIF DE COMMANDE DE COMMUTATEUR ET BLOC-BATTERIE LE COMPRENANT

(30) Priority: 16.12.2022 KR 20220177252
(43) Date of publication of application: 19.06.2024
(73) Proprietor: Samsung SDI Co., Ltd., Yongin-si, Gyeonggi-do 17084 (KR)
(72) Inventor: CHO, Kyusung, 17084 Yongin-si (KR); JEON, Hyuncheol, 17084 Yongin-si (KR)
(74) Representative: Marks & Clerk LLP

(56) References cited:
- EP-A1- 3 575 139
- US-A1- 2013 231 807

## Description

### BACKGROUND

### (a) Field

The present disclosure relates to a switch control device and a battery pack including the same.

### (b) Description of the Related Art

Recently, according to strengthening of environmental regulations including CO₂ regulations, interest in environmentally-friendly vehicles has been increasing. Accordingly, vehicle companies have been actively researching and developing pure electrical vehicles and hydrogen vehicles, as well as hybrid and plug-in hybrid vehicles.

A high voltage battery pack for storing electrical energy obtained from various energy sources is applied to the environmentally-friendly vehicles. A high voltage electric system of a vehicle uses high voltage electrical energy of supplied from a high voltage battery for driving or electrical needs of the vehicle.

When output of the battery pack is suddenly cut off due to a hardware or software problem while a vehicle is using electrical energy of the battery pack, there is a risk of a driving force of the vehicle being lost, and thus the driver may loose control of the vehicle, leading to a safety issue.

EP3575139A1 discloses a switch control circuit and battery pack including the same.

US2013/231807A1 discloses an electronic control device and vehicle control system.

### SUMMARY

The present disclosure has been made in an effort to provide a switch control device, and a battery pack including the same, which is capable of preventing an output of the battery pack from being suddenly cut off due to a temporary fault of the battery pack during operation in an environmentally friendly vehicle.

An embodiment of the present disclosure provides a switch control device according to claim 1.

The retention control circuit may allow the retention circuit to operate in the retention mode when a reset signal is received, and the first controller may output the reset signal according to an operation state of the device.

The retention circuit may include: a latch circuit configured to operate in one of the transfer mode and the retention mode and to output the switch control signal according to a logical product result of the control signal and the safety signal while operating in the transfer mode and retain the switch control signal in a previous state while operating in the retention mode; and a timer circuit configured to operate the latch circuit in the transfer mode when a predetermined time elapses after the latch circuit operates in the retention mode.

The retention circuit may further include an input circuit configured to control switching of the latch circuit to the retention mode and starting a timer of the timer circuit according to the safety signal.

The input circuit may include: a first transistor configured to be turned on or off according to the control signal and to electrically connect a first node and a second node when turned on; and a second transistor configured to be turned on or off according to the safety signal and to electrically connect the second node and a ground when turned on, and the latch circuit may control switching to the retention mode according to a voltage of the second node, and may output the switch control signal according to a voltage of the first node in the transfer mode. The first and second transistors may be **NPN** transistors.

The latch circuit may include: a third transistor configured to be turned on or off according to the voltage of the first node and to electrically connect an output node from which the switch control signal is outputted and a power node when turned on; a fourth transistor configured to be turned on or off according to a voltage of a third node and to electrically connect the first node and the ground when turned on; a first capacitor electrically connected between the power node and the first node; a first resistor electrically connected between the power node and the first node; a second resistor electrically connected between the third node and the output node; and a second capacitor electrically connected between the output node and the ground. A voltage of the third node may be determined by the voltage of the second node, the voltage of the output node, and a voltage applied from the timer circuit. The third transistor may be a PNP transistor, and the fourth transistor may be an NPN transistor.

The latch circuit may further include: a Zener diode configured to include a cathode electrically connected to the second node and an anode electrically connected to the third node; and a fifth transistor that is turned on or off according to the voltage of the third node, and to electrically connect a control terminal of the second transistor and the ground when turned on. The fifth transistor may be a NPN transistor.

The timer circuit may include: a sixth transistor configured to be turned on or off according to a voltage applied to a control terminal of the second transistor and to electrically connect a fourth node and the ground when turned on; a third resistor connected between the power node and the fourth node; a third capacitor connected between the fourth node and the ground; and a seventh transistor configured to be turned on or off according to a voltage of the fourth node and to electrically connect the third node and the ground when turned on. The sixth transistor may be an NPN transistor and the seventh transistor may be a metal oxide semiconductor field effect transistor (P-channel MOSFET).

The retention control circuit may include an off circuit configured to output a timer off signal to the timer circuit to retain a timer operation of the timer circuit in an off state when the disable signal is inputted.

The off circuit may include: an eighth transistor configured to be turned on or off according to a voltage of a fifth node and to electrically connect the power node and a sixth node when turned on; a ninth transistor that is turned on or off according to a voltage of the sixth node and to electrically connect between the fifth node and the ground when turned on; a fourth capacitor electrically connected between the sixth node and the ground; a fourth resistor electrically connected between the power node and a control terminal of the eighth transistor; a fifth resistor electrically connected between the sixth node and a control terminal of the ninth transistor; and a diode configured to include an anode to which the disable signal is inputted and a cathode connected to the sixth node. The eighth transistor may be a PNP transistor, and the ninth transistor may be an NPN transistor. The eighth transistor may be a PNP transistor, and the ninth transistor may be an NPN transistor.

The timer circuit may further include: a second diode configured to include an anode electrically connected to the fourth node and a cathode electrically connected to a control terminal of the seventh transistor; and a third diode configured to include an anode electrically connected to the sixth node and a cathode electrically connected to the control terminal of the seventh transistor.

The retention control circuit may further include a release circuit configured to release an output of the timer off signal of the off circuit when the reset signal is inputted.

The release circuit may include a tenth transistor configured to be turned on or off according to the reset signal and to electrically connect the second node and the ground when turned on, and the tenth transistor may be a NPN transistor.

An embodiment of the present disclosure provides a battery pack including: a battery module configured to include a plurality of cells connected in series or parallel to each other; a switch configured to control electrical connection between the battery module and a load; a driver configured to control opening and closing of the switch; and the aforementioned switch control device. The driver may control opening and closing of the switch according to a switch control signal outputted from the switch control device.

According to the present disclosure, it is possible to improve safety by preventing an output of the battery pack from being suddenly cut off due to a temporary fault of the battery pack during operation in an environmentally friendly vehicle.

At least some of the above features that accord with the invention and other features according to the invention are set out in the claims.

### BRIEF DESCRIPTION OF THE DRAWINGS

FIG. 1 schematically illustrates a switch control device according to an embodiment.
FIG. 2 illustrates a circuit configuration of an example switch control device according to an embodiment.
FIG. 3 schematically illustrates a timing diagram of a switch control device according to an embodiment.
FIG. 4 schematically illustrates a battery pack including a switch control device according to an embodiment.

### DETAILED DESCRIPTION

Embodiments of the present disclosure will now be described in detail with reference to the accompanying drawings. Hereinafter, effects and characteristics of the embodiments and implementation methods thereof will be described in detail with reference to the accompanying drawings. In the drawings, like reference numerals denote like components, and redundant descriptions thereof are omitted. However, the present disclosure may be embodied in various forms, and should not be construed as being limited to the embodiments set forth herein. Rather, these embodiments are provided by way of example to convey aspects and features of the present disclosure to those skilled in the art.

Accordingly, processes, elements, and techniques deemed not necessary to those skilled in the art for complete understanding of aspects and features of the disclosure may not be described. In the drawings, the relative sizes of elements, layers, and regions may be exaggerated for clarity.

The term "and/or" in this document includes any or all combinations of multiple items listed in connection therewith. The use of "can/may" in describing an embodiment of the present disclosure indicates "at least one embodiment of the present disclosure."

Terms in the singular form in this document may include the plural form unless the context clearly dictates otherwise.

In this document, terms including ordinal numbers such as "first", "second", and "third" are used to describe various components, but these components are not limited by these terms. The terms are only used to differentiate one component from other components. For example, without departing from the scope rights described in this document, a first component may be referred to as a second component, and similarly, the second component may also be renamed as the first component.

In this document, when one component or layer is described as "on", "connected to", or "coupled" to another component or layer, "on", "connected to" and "coupled to" "Includes those formed directly or through the intervening of one or more other components or layers. In addition, when one component or layer is described as being "between" two components or layers, it should be understood that it is the only component or layer between two components or layers, or that there are one or more intervening other components or layers.

In this document, a case of electrically connecting two constituent elements includes not only a case of directly connecting the constituent elements but also a case of connecting the constituent elements via another constituent element therebetween. The constituent element therebetween may include a switch, a resistor, a capacitor, and the like. An expression of connection indicates electrical connection unless explicitly described to be direct connection.

Hereinafter, a switch control device and a battery pack including the same according to an embodiment will be described with reference to necessary drawings.

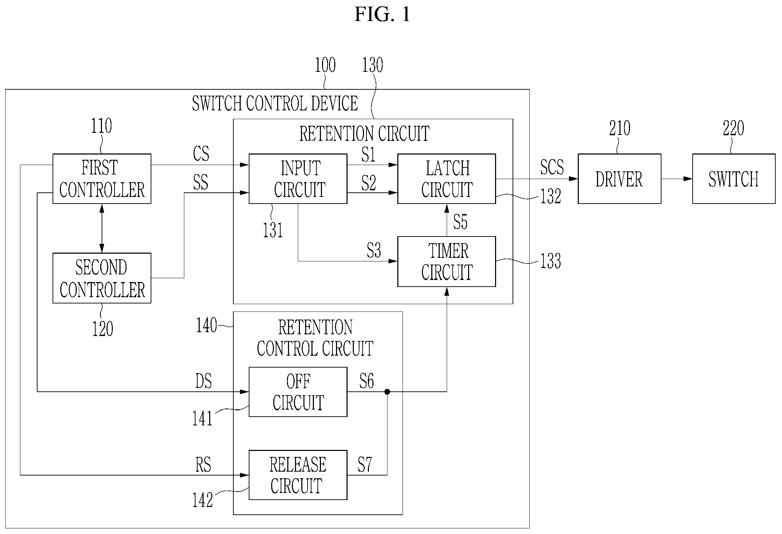

FIG. 1 schematically illustrates a switch control device according to an embodiment.

Referring to FIG. 1, the switch control device 100 may include a first controller 110, a second controller 120, a retention circuit 130 (or holding circuit), and a retention control circuit 140.

The first controller 110 may determine whether to open or close a switch 220 and output a control signal CS for controlling the switch 220. For example, the first controller 110 may output the control signal CS of a high level to turn on (close) the switch 220, and may output the control signal CS of a low level to turn off (open) the switch 220. In this document, the high level and the low level may indicate a voltage level that is higher than a predetermined voltage and a voltage level that is lower than the predetermined voltage, respectively, based on a predetermined voltage. For example, the high level may represent an operation voltage of the first controller 110 or a voltage close to the operation voltage, and the low level may represent a ground voltage or a voltage close to ground voltage.

The first controller 110 may monitor an operation state of a system (e.g., a vehicle) in which the switch control device 100 is mounted, and may output a disable signal DS or a reset signal RS to limit (prohibit) or allow a latch mode operation of the retention circuit 130 described later according to the operation state of the system. The first controller 110 may limit a retention mode operation of the retention circuit 130 by outputting the disable signal DS in a state where the state of the system is not stabilized (abnormal mode), such as when the power is initially turned on. Thereafter, when the system state is stabilized (normal mode), the first controller 110 may output the reset signal RS to allow the retention circuit 130 to operate in the retention mode.

The second controller 120 may monitor an operation state of the first controller 110. For example, the second controller 120 may continuously communicate with the first controller 110, and may determine the operation state of the first controller 110 from a communication state with the first controller 110. In addition, for example, the second controller 120 may periodically receive an error detection signal from the first controller 110 to detect the operation state of the first controller 110, and may determine the operation state of the first controller 110 according to a reception state of the error detection signal (a reception status, a pulse width, a reception period, etc.). The second controller 120 may output a safety signal SS indicating the operation state of the first controller 110, that is, whether the operation is normal. For example, the second controller 120 may output a high-level safety signal during a normal operation of the first controller 110, and may output a low-level safety signal during an abnormal operation of the first controller 110.

The retention circuit 130 may receive the control signal CS and the safety signal SS from the first controller 110 and the second controller 120. The retention circuit 130 may generate a switch control signal SCS according to the control signal CS and the safety signal SS, and may output the switch control signal SCS to the driver 210. The retention circuit 130 may transfer the switch control signal SCS corresponding to the control signal CS input from the first controller 110 to the driver 210 according to the operation state of the first controller 110 indicated by the safety signal SS, or may retain the switch control signal SCS in a previous state regardless of the control signal CS to output it for a predetermined period of time (e.g., 3 s).

When the safety signal SS indicates the normal state of the first controller 110, the retention circuit 130 may operate in a transfer mode for transferring the switch control signal SCS corresponding to the control signal CS input from the first controller 110 to the driver 210. While operating in the transfer mode, the retention circuit 130 may output the switch control signal SCS indicating an off (open) state of the switch 220 to the driver 210 when the control signal CS indicates the off (open) state of the switch 220, and may output the switch control signal SCS indicating an on (closed) state of the switch 220 to the driver 210 when the control signal CS indicates the on (closed) state of the switch 220.

When the safety signal SS indicates the abnormal state of the first controller 110, the retention circuit 130 may operate in a retention mode to retain a level of the switch control signal SCS at a previous state for a predetermined time regardless of the control signal CS inputted from the first controller 110. When entering the retention mode, the retention circuit 130 may retain the retention mode for a predetermined time regardless of the safety signal SS that is subsequently inputted. While operating in the retention mode, the retention circuit 130 may retain the switch control signal SCS in a state of entering the retention mode. When a predetermined time elapses after entering the retention mode, the retention circuit 130 may end the retention mode, and may return to the transfer mode.

The retention circuit 130 may include an input circuit 131, a latch circuit 132, and a timer circuit 133.

The input circuit 131 may receive the control signal CS and the safety signal SS from the first controller 110 and the second controller 120, respectively, and may output signals S1, S2, and S3 for controlling operations of the latch circuit 132 and the timer circuit 133 based on these signals.

The input circuit 131 may control the operation mode of the latch circuit 132 by inactivating or activating a retention function of the latch circuit 132 according to the safety signal SS. When the safety signal SS, inputted in a state in which the retention function of the latch circuit 132 is deactivated, (the state in which the latch circuit 132 operates in the transfer mode) indicates the normal state of the first controller 110, the input circuit 131 may control the latch circuit 132 to operate in the transfer mode by retaining the inactive state of the latch circuit 132. For example, the input circuit 131 may deactivate the retention function of the latch circuit 132 by outputting a latch control signal S2 to the latch circuit 132. When the safety signal SS, inputted in the state in which the retention function of the latch circuit 132 is deactivated, indicates the abnormal state of the first controller 110, the input circuit 131 may activate the retention function of the latch circuit 132 to operate the latch circuit 132 in a retention mode. For example, the input circuit 131 may stop outputting the latch control signal S2 to activate the retention function of the latch circuit 132.

While the latch circuit 132 operates in the transfer mode, the input circuit 131 may control the level of the switch control signal SCS output from the latch circuit 132 by outputting a transfer signal S1 according to the control signal CS to the latch circuit 132.

When the latch circuit 132 operates in the retention mode, the input circuit 131 may output a timer start signal S3 for activating a timer function of the timer circuit 133 to the timer circuit 133.

The latch circuit 132 may deactivate (off) or activate (on) the retention function according to the latch control signal S2 received from the input circuit 131. For example, the latch circuit 132 may deactivate the retention function while the latch control signal S2 is received from the input circuit 131, and may activate the retention function when the latch control signal S2 is not received from the input circuit 131.

When the retention function is deactivated, the latch circuit 132 may operate in the transfer mode to control an output level of the switch control signal SCS according to the transfer signal S1 received from the input circuit 131. The latch circuit 132 may operate in the retention mode when the retention function is activated, and may retain the switch control signal SCS in a previous state for a predetermined time to output it.

The latch circuit 132 may operate in the retention mode, may automatically release the retention mode when a predetermined time elapses, and may operate in the transfer mode. A retention mode operation time of the latch circuit 132 may be controlled by the timer circuit 133. The latch circuit 132 may operate in the retention mode while a timer function of the timer circuit 133 is activated (on), and when the timer function is ended (off), the retention mode may be ended and switched to the transfer mode.

The timer circuit 133 may activate (on) the timer function according to the timer start signal S3 received from the input circuit 131. When the timer function is activated, the timer circuit 133 may check a time elapsed from when the timer function is activated. The timer circuit 133 may output a timer end signal S5 to the latch circuit 132 when a predetermined time elapses from when the timer function is activated, and may deactivate (off) the timer function.

When the timer end signal S5 is received from the timer circuit 133, the latch circuit 132 may deactivate the retention function, and may operate in the transfer mode.

The retention control circuit 140 may receive the disable signal DS or the reset signal RS from the first controller 110. The retention control circuit 140 may limit or allow the retention mode operation of the retention circuit 130 according to the disable signal DS or the reset signal RS received from the first controller 110.

The retention control circuit 140 may include an off circuit 141 and a release circuit 142.

The off circuit 141 may receive the disable signal DS from the first controller 110. The off circuit 141 may limit the retention mode operation of the retention circuit 130 when the disable signal DS is received. When the disable signal DS is received, the off circuit 141 may retain the timer function of the timer circuit 133 in an inactive (off) state by outputting a timer off signal S6. While the timer function of the timer circuit 133 retains an off state, an operation of the latch circuit 132 in the retention mode regardless of the safety signal SS may be restricted.

The release circuit 142 may receive the reset signal RS from the first controller 110. When the reset signal RS is received, the release circuit 142 may allow the retention circuit 130 to operate in the retention mode. When the reset signal RS is received, the release circuit 142 may output a release signal S7 for releasing the timer off signal S6 of the timer circuit 133. When the release signal S7 is inputted from the release circuit 142, the off circuit 141 may stop outputting the timer off signal S6, and accordingly, operation restriction of the timer circuit 133 may be released.

The timer circuit 133 may retain the timer function in an off (inactivated) state regardless of the timer start signal S3 while the timer off signal S6 is received. Then, when the release signal S7 is received, the timer circuit 133 may control the timer function to be activated or deactivated (on or off) according to the timer start signal S3.

The driver 210 may control the switch 220 (e.g., a contactor, a relay, etc.) to be on (closed) or off (open) according to the switch control signal SCS received from the switch control device 100. For example, the driver 210 may control the switch 220 to be in an on (closed) state when the switch control signal SCS is at a high level, and may control the switch 220 to an off (open) state when the switch control signal SCS is at a low level.

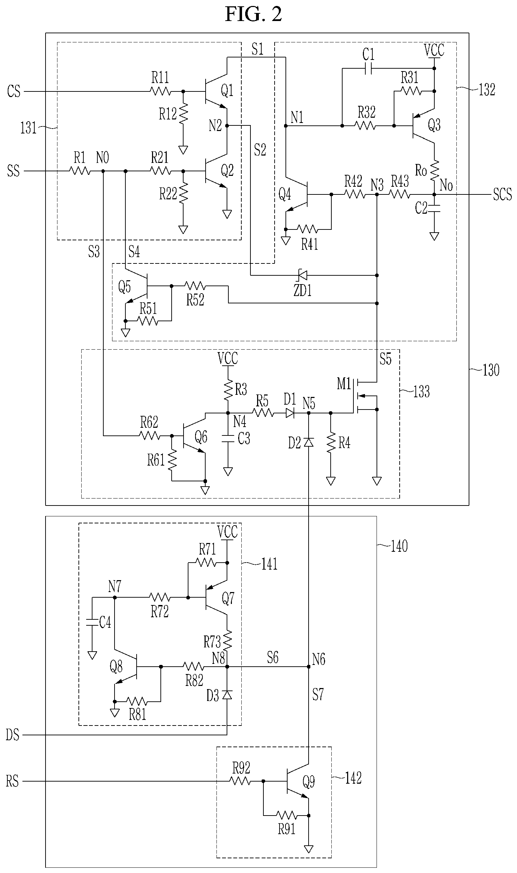

FIG. 2 illustrates a circuit configuration of the switch control device 100 according to an embodiment.

Referring to FIG. 2, the input circuit 131 of the retention circuit 130 may include two transistors Q1 and Q2 connected in series between a node **N1** and a ground. The transistor Q1 may include a control terminal to which the control signal CS is inputted, a first terminal electrically connected to the node N1, and a second terminal electrically connected to a node N2. The transistor Q2 may include a control terminal to which the safety signal SS is inputted, a first terminal electrically connected to the node N2, and a second terminal electrically connected to the ground. The input circuit 131 may further include resistors R11 and R12 electrically connected to the control terminal of the transistor Q1 for a stable operation of the transistor Q1, and resistors R21 and R22 electrically connected to the control terminal of the transistor Q2 for a stable operation of the transistor Q2. The input circuit 131 may further include a resistor R1 electrically connected between a terminal from which the safety signal SS is outputted from the second controller 120 and a node N0.

The transistor Q1 may be turned on or turned off according to the control signal CS. The transistor Q1 may be turned on when the control signal CS is at a level for turning on the switch 220 (e.g., a high level), and may be turned off when the control signal CS is at a level for turning off the switch 220 (e.g., a low level). The transistor Q2 may be turned on or off according to the safety signal SS. The transistor Q2 may be turned on when the safety signal SS is at a level indicating the normal state of the first controller 110 (e.g., a high level), and may be turned off when the safety signal SS is at a level (e.g., low level) indicating the abnormal state of the first controller 110. When the transistor Q2 is turned on, the node N2 and the ground may be electrically connected through the transistor Q2. When the transistor Q1 is turned on, the node N1 and the node N2 may be electrically connected through the transistor Q1. Accordingly, when the transistors Q1 and Q2 are turned on, a low-level transfer signal S1 may be outputted to the node N1. On the other hand, when any one of the transistors Q1 and Q2 is turned off, connection between the node N1 and the ground may be cut off.

The transistors Q1 and Q2 may be NPN transistors in which a control terminal is a base terminal, and a first terminal and a second terminal are a collector terminal and an emitter terminal, respectively. The transistor Q1 may be turned on when the high-level control signal CS is inputted, and turned off when the low-level control signal CS is inputted. In addition, the transistor Q2 may be turned on when the high-level safety signal SS is inputted, and turned off when the low-level safety signal SS is inputted.

The latch circuit 132 of the retention circuit 130 may include two transistors Q3 and Q4 for performing a retention function. The transistor Q3 may include a control terminal electrically connected to the node N1, a first terminal electrically connected to a power node VCC, and a second terminal electrically connected to an output node No. The transistor Q4 may include a control terminal electrically connected to the output node No, a first terminal electrically connected to the node N1, and a second terminal electrically connected to the ground. The power node VCC may be a node to which a power voltage is applied from a power source (not illustrated). For example, the power node VCC may be a node connected to a power supply supplying an operation voltage to the first controller 110 and the second controller 120, and a same voltage as operation voltages of the first controller 110 and the second controller 120 may be applied to the power node VCC.

The latch circuit 132 may include a resistor R31 electrically connected between the control terminal and the first terminal of the transistor Q3, a resistor R32 electrically connected between the node N1 and the control terminal of the transistor Q3, and a capacitor C1 electrically connected between the power node VCC and the node N1. The latch circuit 132 may further include a resistor Ro electrically connected between the second terminal of the transistor Q3 and the output node No, and a capacitor C2 electrically connected between output node No and the ground. The latch circuit 132 may include a resistor R41 electrically connected between the control terminal and the second terminal of the transistor Q4, a resistor R42 electrically connected between the control terminal of the transistor Q4 and the node N3, and a resistor R43 electrically connected between the node N3 and the output node No.

The transistor Q3 may be turned on or off by a voltage applied to the node N1. When the transistor Q3 is turned on, a voltage applied to the power node VCC may be transferred to the output node No to allow the high level switch control signal SCS to be outputted to the output node No. When the transistor Q3 is turned off, connection between the power node VCC and the output node No may be cut off to allow the low level switch control signal SCS to be output to the output node No.

Turn-on or turn-off of the transistor Q4 may be controlled by a voltage applied to the node N3. When turned on, the transistor Q4 may electrically connect the node N1 to the ground.

The transistor Q3 may be a PNP transistor having a control terminal as a base terminal and first and second terminals as an emitter terminal and a collector terminal, respectively. Accordingly, the transistor Q3 may be turned on when a voltage that is lower than a predetermined voltage is applied to the node N1, and turned off when a voltage that is equal to or higher than the predetermined voltage is applied to the node N1. When both the transistor Q1 and the transistor Q2 are turned on, the low-level transfer signal S1 may be applied to the node N1. In addition, even when the transistor Q4 is turned on, the node N1 may be electrically connected to the ground to allow a low level voltage to be applied to the node N1. On the other hand, when all of the transistors Q1, Q2, and Q4 are turned off, a voltage that is higher than a predetermined voltage may be applied to the node N1 through the capacitor C1 and the resistors R31 and R32. Accordingly, the transistor Q3 may be turned on when both the control signal CS and the safety signal SS are at a high level so that both the transistors Q1 and Q2 are turned on, or the transistor Q4 is turned on.

The transistor Q4 may be an NPN transistor in which a control terminal is a base terminal, and a first terminal and a second terminal are a collector terminal and an emitter terminal, respectively. Accordingly, the transistor Q4 may be turned on when a voltage that is greater than a predetermined voltage is applied to the node N3, and turned off when a voltage that is equal to or lower than the predetermined voltage is applied to the node N3. When the transistor Q4 is turned on, the transistor Q3 may be turned on regardless of the transfer signal S1 to retain the switch control signal SCS at a high level. On the other hand, when the transistor Q4 is turned off, the transistor Q3 may control a level of the switch control signal SCS according to the transfer signal S1.

The latch circuit 132 may further include a Zener diode ZD1 and a transistor Q5. The Zener diode ZD1 may have an anode electrically connected to the node N3 and a cathode electrically connected to the node N2. The transistor Q5 may include a control terminal electrically connected to the node N3, a first terminal electrically connected to the node N0, and a second terminal electrically connected to the ground. The latch circuit 132 may further include resistors R51 and R52 electrically connected to a control terminal of the transistor Q5 for a stable operation of the transistor Q5.

While the high-level safety signal SS is inputted to retain a turned-on state of the transistor Q2, the low-level latch control signal S2 may be outputted to the node N2. While the low-level latch control signal S2 is being output, a voltage that is lower than or equal to a predetermined voltage may be applied to the node N3, and accordingly, the transistor Q4 may retain a turned-off state.

When the low-level safety signal SS is inputted and the transistor Q2 is turned off, output of the low-level latch control signal S2 may be stopped. Accordingly, a voltage of the node N3 may be determined according to the level of the switch control signal SCS being outputted through the output node No when the transistor Q2 is turned off. When the switch control signal SCS has a high level, a voltage that is equal to or higher than a predetermined voltage may be applied to the node N3, and accordingly, the transistor Q4 may be turned on to allow the retention function to be activated.

The transistor Q5 may be turned on or off according to a voltage applied to the node N3. When the transistor Q5 is turned on, a low-level retention signal S4 may be outputted to the node N0. While the low-level retention signal S4 is outputted to the node N0, the transistor Q2 may retain a turned-off state regardless of the level of the safety signal SS.

The transistor Q5 may be an NPN transistor in which a control terminal is a base terminal, and a first terminal and a second terminal are a collector terminal and an emitter terminal, respectively. Accordingly, the transistor Q5 is turned on when a voltage that is greater than a predetermined voltage is applied to the node N3, and turned off when a voltage that is equal to or lower than the predetermined voltage is applied to the node N3. That is, the transistor Q5 may be turned on like when the transistor Q4 is turned on (when the retention function of the latch circuit 132 is activated), to allow the transistor Q2 to be controlled to be turned off. Thereafter, the transistor Q2 may retain a turned-off state until the transistor Q4 is turned off again.

The timer circuit 133 of the retention circuit 130 may include a transistor M1, a transistor Q6, a resistor R3, and a capacitor C3. The transistor M1 may include a control terminal electrically connected to the node N5, a first terminal electrically connected to the node N3, and a second terminal electrically connected to the ground. The transistor Q6 may include a control terminal electrically connected to the node N0, a first terminal electrically connected to the node N4, and a second terminal electrically connected to the ground. The resistor R3 may be electrically connected between the power node VCC and the node N4. The capacitor C3 may be electrically connected between the node N4 and the ground.

The timer circuit 133 may further include resistors R61 and R62 electrically connected to a control terminal of the transistor Q6 for a stable operation of the transistor Q6. The timer circuit 133 may further include a resistor R4 electrically connected between a control terminal of the transistor M1 and the ground. The timer circuit 133 may further include a resistor R5 electrically connected to node N4, a diode D1 electrically connected between the resistor R5 and the control terminal of the transistor M1, and a diode D2 electrically connected between a node N5 and a node N6 of the retention control circuit 140. The diodes D1 and D2 may perform a function of limiting a current direction. The diode D1 may have an anode electrically connected to the node N4 through the resistor R5 and a cathode electrically connected to the node N5. The diode D2 has an anode electrically connected to the node N6 of the retention control circuit 140 and a cathode electrically connected to the node N5.

The transistor Q6 may be turned on or off according to the timer start signal S3 inputted from the node N0. When the transistor Q6 is turned on, the node N4 may be connected to the ground by the transistor Q6. When the transistor Q6 is turned off, the capacitor C3 may be charged by a voltage applied to the power node VCC to allow the voltages of the nodes N4 and N5 to gradually increase.

The transistor Q6 may be an NPN transistor in which a control terminal is a base terminal, and a first terminal and a second terminal are a collector terminal and an emitter terminal, respectively. Accordingly, the transistor Q6 may be turned on when a high-level timer start signal S3 is inputted from the node N0, and may be turned off when the low-level timer start signal S3 is inputted from the node N0. The timer start signal S3 may become a low level when the safety signal SS is at a low level or when the transistor Q5 is turned on. The timer start signal S3 may become a high level when the safety signal SS is at a high level and the transistor Q5 is turned off. That is, the transistor Q6 may be turned off when the safety signal SS is at a low level or the transistor Q5 is turned on, and turned on when the safety signal SS is at a high level and the transistor Q5 is turned off.

The transistor M1 may be turned on or off according to a voltage applied to the node N5. When turned on, the transistor M1 may output a low-level timer end signal S5 to the node N3.

The transistor M1 may be a N-channel metal oxide semiconductor field effect transistor (N-channel MOSFET) in which a control terminal is a gate terminal, and a first terminal and a second terminal are a drain terminal and a source terminal, respectively. Accordingly, the transistor M1 may be turned on when a voltage that is greater than a predetermined voltage is applied to the node N5, and turned off when a voltage that is equal to or lower than the predetermined voltage is applied to the node N5. When the transistor Q6 is turned off to allow a voltage applied to the node N5 to be higher than a predetermined voltage, the transistor M1 may be turned on to output the low-level timer end signal S5 to the node N3. In this case, after the transistor Q6 is turned off, a predetermined delay time (e.g., 3 s) may occur until a voltage sufficient to turn on the transistor M1 is applied to the node N5. Due to such a delay time, after the transistor Q6 is turned off by the timer start signal S3, a predetermined delay may occur until the timer end signal S5 is applied to the node N3 to deactivate the retention function of the latch circuit 132.

The off circuit 141 of the retention control circuit 140 may include two transistors Q7 and Q8 for performing a retention function. The transistor Q7 may include a control terminal electrically connected to the node N7, a first terminal electrically connected to a power node VCC, and a second terminal electrically connected to a node N8. The transistor Q8 may include a control terminal electrically connected to the node N8, a first terminal electrically connected to the node N7, and a second terminal electrically connected to the ground.

The off circuit 141 may further include a resistor R71 electrically connected between a control terminal and a first terminal of the transistor Q7, a resistor R72 electrically connected between the node N7 and the control terminal of the transistor Q7, a resistor R73 electrically connected between the second terminal of the transistor Q7 and the node N8, and a capacitor C4 electrically connected between the node N7 and the ground. The off circuit 141 may further include a resistor R81 electrically connected between a control terminal and a second terminal of the transistor Q8, a resistor R82 electrically connected between the control terminal of the transistor Q8 and the node N8, and a diode D3 electrically connected to the node N8. The diode D3 may receive the disable signal DS through an anode terminal, and a cathode terminal thereof may be electrically connected to the node N8. The diode D3 may perform a function of limiting a current direction.

The transistor Q7 may be turned on or off by a voltage applied to the node N7. When the transistor Q7 is turned on, the power node VCC and the node N8 may be connected to each other to allow the high level timer off signal S6 to be outputted to the node N8 and the node N6.

The transistor Q8 may be turned on or off by a voltage applied to the node N8. When turned on, the transistor Q8 may connect the ground and the node N7.

The transistor Q7 may be a PNP transistor having a control terminal as a base terminal and first and second terminals as an emitter terminal and a collector terminal, respectively. Accordingly, the transistor Q7 may be turned on when a voltage that is lower than a predetermined voltage is applied to the node N7, and turned off when a voltage that is equal to or higher than the predetermined voltage is applied to the node N7. When the transistor Q8 is turned on, the node N7 may be connected to the ground through the transistor Q8. Accordingly, when the transistor Q8 is turned on, the transistor Q7 may also be turned on. On the other hand, when the transistor Q8 is turned off, a voltage that is equal to or higher than a predetermined voltage may be applied to the node N7 by the capacitor C4 and the resistors R71 and R72, and the transistor Q7 may be turned off.

The transistor Q8 may be an NPN transistor in which a control terminal is a base terminal, and a first terminal and a second terminal are a collector terminal and an emitter terminal, respectively. Accordingly, the transistor Q8 may be turned on when a voltage that is higher than a predetermined voltage is applied to the node N8. When the high-level disable signal DS is inputted or the transistor Q7 is turned on, a signal having a higher voltage than a predetermined voltage (high-level timer off signal S6) may be applied to the node N8. Accordingly, the transistor Q8 may be turned on when the high-level disable signal DS is inputted, and thereafter, the high-level timer off signal S6 may be applied to the node N8 by the turned-on transistor Q7 to allow the turned-on state to be retained. As such, even when the disable signal DS is inputted as a single pulse signal, the off circuit 141 may retain the high-level timer off signal S6 to allow it to be continuously outputted to the node N6.

The timer off signal S6 outputted by the off circuit 141 may be transferred to the node N5 of the timer circuit 133. While the high-level timer off signal S6 from the off circuit 141 is outputted to the node N5, the transistor M1 remains turned on and a retention mode operation of the latch circuit 132 may be limited.

The release circuit 142 of the retention control circuit 140 may include a transistor Q9. The transistor Q9 may include a control terminal to which the reset signal RS is inputted, a first terminal electrically connected to the node N6, and a second terminal electrically connected to the ground. The release circuit 142 may further include resistors R91 and R92 electrically connected to a control terminal of the transistor Q9 for a stable operation of the transistor Q9.

The transistor Q9 may be turned on or off by the reset signal RS. When turned on, the transistor Q9 may output a low-level release signal S7 to the node N6.

The transistor Q9 may be an **NPN** transistor in which a control terminal is a base terminal, and a first terminal and a second terminal are a collector terminal and an emitter terminal, respectively. Accordingly, when the reset signal RS is applied, the transistor Q9 may be turned on to allow the low-level release signal S7 to be outputted to the node N6. When the transistor Q9 is turned on and the low-level release signal S7 is applied to the node N6, the transistor Q8 of the off circuit 141 may be turned off to allow the latch operation of the off circuit 141 to be released. Accordingly, the output of the high level timer off signal S6 may be stopped to allow the latch circuit 132 to operate in the retention mode.

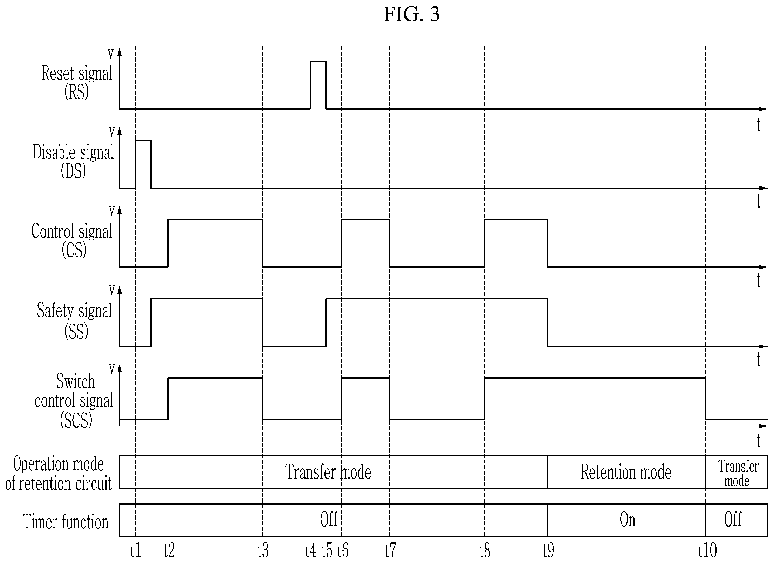

Hereinafter, an operation of the switch control device 100 according to an embodiment will be described in more detail with reference to FIG. 2 and FIG. 3.

FIG. 3 schematically illustrates a timing diagram of the switch control device 100 according to an embodiment.

Referring to FIG. 3, when the operation of the latch circuit 132 in the retention mode is to be limited, the first controller 110 may output the disable signal DS formed of one pulse signal once (see time t1). Accordingly, all of the transistors Q7 and Q8 of the off circuit 141 are turned on to allow the off circuit 141 to operate as a latch circuit that continuously output the high-level timer off signal S6. In addition, the transistor M1 of the timer circuit 133 may be retained in a turned-on state by the high-level timer off signal S6 continuously outputted from the off circuit 141. While the transistor M1 remains turned on, the transistor Q4 of latch circuit 132 may remain turned off, thereby limiting the retention mode operation of the latch circuit 132.

As a retention mode operation of the latch circuit 132 is restricted, the latch circuit 132 may operate only in the transfer mode regardless of the safety signal SS. While operating in transfer mode, the transistor Q3 may be controlled to turn on or turn off according to the control signal CS. Accordingly, the switch control signal SCS having a level that is controlled according to the control signal CS may be outputted to the driver 210. That is, when the high level control signal CS is outputted from the first controller 110, the transistor Q3 may be turned on to output the high-level switch control signal SCS to the driver 210 (see time t2), and when the low-level control signal CS is outputted from the first controller 110, the transistor Q3 may be turned off to allow the low-level switch control signal SCS to be outputted to the driver 210 (see time t3).

Then, the first controller 110 may output the reset signal RS composed of one pulse signal to allow the latch circuit 132 to operate in the retention mode (see time t4). Accordingly, the transistor Q9 of the release circuit 142 may be turned on, and a low-level release signal S7 may be outputted to the off circuit 141. In addition, all of the transistors Q7 and Q8 of the off circuit 141 may be turned off by the release signal S7 to allow the timer off state generated by the off circuit 141 to be released. That is, the retention mode operation of the latch circuit 132 may be allowed.

When the retention mode operation of the latch circuit 132 is allowed, the latch circuit 132 may operate in the transfer mode or the retention mode according to the safety signal SS. That is, when the high-level safety signal SS is outputted from the second controller 120, the transistor Q4 may be turned off to allow the latch circuit 132 to operate in the transfer mode (see time t5). In addition, when the low-level safety signal SS is outputted from the second controller 120, the transistor Q4 may be turned on to allow the latch circuit 132 to operate in the retention mode (see time t9).

As described above, while the latch circuit 132 operates in the transfer mode, the switch control signal SCS corresponding to the control signal CS may be outputted to the driver 210. That is, when the high level control signal CS is outputted from the first controller 110, the high-level switch control signal SCS may be outputted to the driver 210 (see times t6 and t8), and when the low-level control signal CS is outputted from the first controller 110, the low-level switch control signal SCS may be outputted to the driver 210 (see time t7).

On the other hand, while the latch circuit 132 operates in the retention mode, the switch control signal SCS may retain a previous state, i.e., a state at a time when the latch circuit 132 operates in the retention mode (see a period t9 to t10). An operating time of the latch circuit 132 in the retention mode may be controlled by the timer circuit 133. When the latch circuit 132 starts to operate in the retention mode (see time t9), the transistor Q5 of the timer circuit 133 may be turned off to allow the timer function of the timer circuit 133 to be turned on. When the timer function is turned on, the capacitor C3 of the timer circuit 133 may be gradually charged, and when a predetermined time elapses, the transistor M1 may be turned on by a voltage charged in the capacitor C3. When the transistor M1 is turned on, the transistor Q4 of the latch circuit 132 may be turned off to allow the retention function of the latch circuit 132 to be deactivated and the timer function of the timer circuit 133 to also be turned off (time t10).

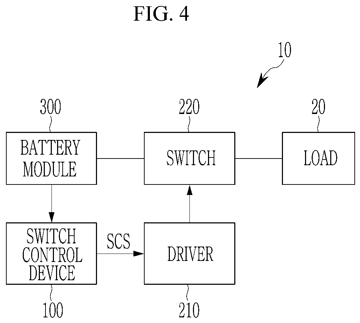

FIG. 4 schematically illustrates a battery pack including a switch control device according to an embodiment.

Referring to FIG. 4, the battery pack 10 may include a battery module 300, a switch 220, a driver 210, and a switch control device 100.

The battery module 300 may include one or more cells that are connected in series or in parallel with each other.

The switch 220 may control electrical connection between the battery module 300 and a load 20, and the switch driver 210 may drive the switch 220 according to the switch control signal SCS. The switch 220 may include a contactor, a relay, and the like.

The switch control device 100 may output the switch control signal SCS to the driver 210 to control an open or closed state of the switch 220. As described with reference to FIG. 1 and 2, the switch control device 100 may include a first controller 110, a second controller 120, a retention circuit 130, and a retention control circuit 140.

The first controller 110 of the switch control device 100 may be a battery management system (BMS) of the battery pack 10. In this case, the first controller 110 may output the control signal CS, the disable signal DS, the reset signal RS, and the like based on state information of the battery module 300, state information of the system (e.g., a vehicle) in which the battery pack 10 is mounted, a driving mode, and the like. For example, the first controller 110 may determine whether to open or close the switch 220 according to the state of the battery pack 10 or a system in which the battery pack 10 is mounted, and may output the control signal CS for controlling the switch 220. In addition, for example, the first controller 110 may output the disable signal DS to limit the retention mode operation of the retention circuit 130 when the battery pack 10 or the system in which the battery pack 10 is mounted is in an abnormal state (e.g., when the power is initially turned on) that may cause the retention circuit 130 to malfunction. Then, when the battery pack 10 or the system in which the battery pack 10 is mounted stabilizes to enter the normal mode, the first controller 110 may output the reset signal RS to allow retention mode operation of the retention circuit 130.

The second controller 120 of the switch control device 100 may be a system basis chip (SBC). The SBC may include an integrated circuit (IC) in which a voltage regulator, a supervisory function, a reset generator, a watchdog function, a communication bus interface, and a wake-up logic are integrated.

As described above, in the switch control device 100 according to an embodiment, the final switch control signal SCS is configured to be outputted according to a logical product (AND) result of the control signal CS and the safety signal SS instead of the control signal CS and the safety signal SS operating in parallel. That is, the switch control device 100 operates to output the high-level switch control signal SCS (indicating that switch 220 is on) only when the high-level control signal CS (instruction to turn on the switch 220) and the high-level safety signal SS (when the first controller 110 is operating normally) are inputted. Accordingly, the switch control signal SCS may be fixed to be used as it is without a need to switch signals for switch control at a time when the safety signal SS changes to an off (low level) state, and thus chattering due to delay errors between parts may be prevented during operation of the retention circuit. In addition, it is possible to prevent malfunction of the switch control device 100 in a noisy environment of a vehicle by ensuring that the switch control signal SCS is finally outputted in an on (high level) state only when both the control signal CS and the safety signal SS are on (high level).

In addition, the switch control device 100 may check a state of a vehicle equipped with the switch control device 100 to determine whether it is necessary to limit the retention mode operation of the retention circuit 130, may limit the retention circuit 130 from operating in a retention mode using the disable signal DS when the limit is needed, and may prevent malfunction of the switch control device 100 due to a vehicle condition by allowing the retention mode operation of the retention circuit 130 using the reset signal RS when the limit is not required. In addition, even when a problem occurs in the first controller 110, the limited or allowed state of the retention mode operation may be retained by controlling limiting or allowing of the retention mode operation of the retention circuit 130 using one pulse signal.

While embodiments of the present disclosure have been particularly shown and described with reference to the accompanying drawings, the specific terms used herein are only for the purpose of describing the disclosure and are not intended to define the meanings thereof or be limiting of the scope of the disclosure set forth in the claims. Therefore, a person of ordinary skill in the art will understand that various modifications and other equivalent embodiments of the present disclosure are possible. Consequently, the true technical protective scope of the present disclosure is defined in the appended claims.

### <Description of Symbols>

10: battery pack
20: load
100: switch control device
110: first controller
120: second controller
130: retention circuit
131: input circuit
132: latch circuit
133: timer circuit
140: retention control circuit
141: off circuit
142: release circuit
210: diver
220: switch
300: battery module

## Claims

1. A switch control device (100) for opening and closing a switch to control electrical connection between a battery module and a load, the switch control device comprising:
a first controller (110);
a retention circuit (130) configured to receive a control signal (CS) and a safety signal (SS) and to operate in two modes, said two modes comprising:
when the safety signal indicates a normal state of the first controller, a transfer mode for outputting a switch control signal having a level that is changed according to the control signal;
and
when the safety signal indicates an abnormal state of the first controller, a retention mode for retaining the switch control signal in a previous state for a predetermined time,
a retention control circuit (140) configured to prohibit an operation of the retention circuit in the retention mode when a disable signal (DS) is received;
the first controller being being configured to monitor a state of a device in which the switch control device is mounted and to output the control signal to control the switch and to output the disable signal according to the operation state of the device in which the switch control device is mounted; and
a second controller (120) configured to output the safety signal according to the operation state of the first controller,
wherein the retention circuit operates in the transfer mode regardless of the safety signal while operation in the retention mode is prohibited by the retention control circuit.

2. The switch control device of claim 1, wherein
the retention control circuit allows the retention circuit to operate in the retention mode when a reset signal is received, and
the first controller outputs the reset signal according to the operation state of the device.

3. The switch control device of claim 1 or claim 2, wherein
the retention circuit includes:
a latch circuit configured to operate in one of the transfer mode and the retention mode and to output the switch control signal according to a logical product result of the control signal and the safety signal while operating in the transfer mode and retain the switch control signal in a previous state while operating in the retention mode; and
a timer circuit configured to operate the latch circuit in the transfer mode when a predetermined time elapses after the latch circuit operates in the retention mode.

4. The switch control device of claim 3, wherein
the retention circuit further includes
an input circuit configured to control switching of the latch circuit to the retention mode and starting a timer of the timer circuit according to the safety signal.

5. The switch control device of claim 4, wherein
the input circuit includes:
a first transistor configured to be turned on or off according to the control signal and to electrically connect a first node and a second node when turned on; and
a second transistor configured to be turned on or off according to the safety signal and to electrically connect the second node and a ground when turned on,
wherein the latch circuit controls switching to the retention mode according to a voltage of the second node, and outputs the switch control signal according to a voltage of the first node in the transfer mode,
wherein, optionally, the first and second transistors are NPN transistors.

6. The switch control device of claim 5, wherein
the latch circuit includes:
a third transistor configured to be turned on or off according to the voltage of the first node and to electrically connect an output node from which the switch control signal is outputted and a power node when turned on;
a fourth transistor configured to be turned on or off according to a voltage of a third node and to electrically connect the first node and the ground when turned on;
a first capacitor electrically connected between the power node and the first node;
a first resistor electrically connected between the power node and the first node;
a second resistor electrically connected between the third node and the output node; and
a second capacitor electrically connected between the output node and the ground,
wherein a voltage of the third node is determined by the voltage of the second node, the voltage of the output node, and a voltage applied from the timer circuit, wherein, optionally,
the third transistor is a PNP transistor, and the fourth transistor is an NPN transistor.

7. The switch control device of claim 6, wherein
the latch circuit further includes:
a Zener diode configured to include a cathode electrically connected to the second node and an anode electrically connected to the third node; and
a fifth transistor that is turned on or off according to the voltage of the third node, and to electrically connect a control terminal of the second transistor and the ground when turned on,
wherein the fifth transistor is an NPN transistor.

8. The switch control device of claim 6 or claim 7, wherein
the timer circuit includes:
a sixth transistor configured to be turned on or off according to a voltage applied to a control terminal of the second transistor and to electrically connect a fourth node and the ground when turned on;
a third resistor connected between the power node and the fourth node;
a third capacitor connected between the fourth node and the ground; and
a seventh transistor configured to be turned on or off according to a voltage of the fourth node and to electrically connect the third node and the ground when turned on,, wherein, optionally,
the sixth transistor is an NPN transistor, and the seventh transistor is a metal oxide semiconductor field effect transistor (P-channel MOSFET).

9. The switch control device of any preceding claim, wherein
the retention control circuit includes
an off circuit configured to output a timer off signal to the timer circuit to retain a timer operation of the timer circuit in an off state when the disable signal is inputted.

10. The switch control device of claim 9 when dependent on one of claims 6 to 8, wherein
the off circuit includes:
an eighth transistor configured to be turned on or off according to a voltage of a fifth node and to electrically connect the power node and a sixth node when turned on;
a ninth transistor that is turned on or off according to a voltage of the sixth node and to electrically connect between the fifth node and the ground when turned on;
a fourth capacitor electrically connected between the sixth node and the ground;
a fourth resistor electrically connected between the power node and a control terminal of the eighth transistor;
a fifth resistor electrically connected between the sixth node and a control terminal of the ninth transistor; and
a diode configured to include an anode to which the disable signal is inputted and a cathode connected to the sixth node,
wherein the timer off signal is outputted to the sixth node when the eighth transistor and the ninth transistor are turned on.

11. The switch control device of claim 10, wherein
the eighth transistor is a PNP transistor, and the ninth transistor is an NPN transistor.

12. The switch control device of claim 11, wherein
the timer circuit further includes:
a second diode configured to include an anode electrically connected to the fourth node and a cathode electrically connected to a control terminal of the seventh transistor; and
a third diode configured to include an anode electrically connected to the sixth node and a cathode electrically connected to the control terminal of the seventh transistor.

13. The switch control device of any of claims 10 to 12, wherein
the retention control circuit further includes
a release circuit configured to release an output of the timer off signal of the off circuit when the reset signal is inputted.

14. The switch control device of claim 13, wherein
the release circuit includes
a tenth transistor configured to be turned on or off according to the reset signal and to electrically connect the second node and the ground when turned on, and
wherein the tenth transistor is an NPN transistor.

15. A battery pack (10) comprising:
a battery module (300) configured to include a plurality of cells connected in series or parallel to each other;
a switch (220) configured to control electrical connection between the battery module and a load (20);
a driver (210) configured to control opening and closing of the switch; and
the switch control device (100) according to any one of claims 1 to 14,
wherein the driver controls opening and closing of the switch according to a switch control signal outputted from the switch control device.

## Patentansprüche

1. Schaltersteuervorrichtung (100) zum Öffnen und Schließen eines Schalters zum Steuern der elektrischen Verbindung zwischen einem Batteriemodul und einer Last, wobei die Schaltersteuervorrichtung umfasst:
eine erste Steuereinheit (110);
eine Halteschaltung (130), die konfiguriert ist, um ein Steuersignal (CS) und ein Sicherheitssignal (SS) zu empfangen und in zwei Modi zu arbeiten, wobei die beiden Modi umfassen:
wenn das Sicherheitssignal einen Normalzustand der ersten Steuereinheit anzeigt, einen Übertragungsmodus zum Ausgeben eines Schaltersteuersignals, dessen Pegel entsprechend dem Steuersignal geändert wird; und
wenn das Sicherheitssignal einen anomalen Zustand der ersten Steuereinheit anzeigt, einen Haltemodus zum Halten des Schaltersteuerungssignals in einem vorherigen Zustand für eine vorgegebene Zeit,
eine Haltesteuerschaltung (140), die konfiguriert ist, um den Betrieb der Halteschaltung im Haltemodus zu unterbinden, wenn ein Deaktivierungssignal (DS) empfangen wird;
wobei die erste Steuereinheit konfiguriert ist, um einen Zustand einer Vorrichtung zu überwachen, in der die Schaltersteuervorrichtung montiert ist, und
das Steuersignal zum Steuern des Schalters ausgeben und das Deaktivierungssignal gemäß dem Betriebszustand der Vorrichtung, in der die Schaltersteuereinheit montiert ist, auszugeben; und
eine zweite Steuereinheit (120), die konfiguriert ist, um das Sicherheitssignal gemäß dem Betriebszustand der ersten Steuereinheit auszugeben,
wobei die Halteschaltung unabhängig vom Sicherheitssignal im Übertragungsmodus arbeitet, während der Betrieb im Haltemodus durch die Haltesteuerschaltung unterbunden wird.

2. Schaltersteuervorrichtung nach Anspruch 1, wobei
die Haltesteuerschaltung es der Halteschaltung ermöglicht, im Haltemodus zu arbeiten, wenn ein Rücksetzsignal empfangen wird, und
die erste Steuereinheit das Rücksetzsignal gemäß dem Betriebszustand der Vorrichtung ausgibt.

3. Schaltersteuervorrichtung nach Anspruch 1 oder Anspruch 2, wobei
die Halteschaltung einschließt:
eine Verriegelungsschaltung, die konfiguriert ist, um entweder im Übertragungsmodus oder im Haltemodus zu arbeiten und das Schaltersteuersignal gemäß einem logischen Produktresultat des Steuersignals und des Sicherheitssignals auszugeben, während sie im Übertragungsmodus arbeitet, und das Schaltersteuersignal in einem vorherigen Zustand zu halten, während sie im Haltemodus arbeitet; und
eine Zeitgeberschaltung, die konfiguriert ist, um die Verriegelungsschaltung im Übertragungsmodus zu betreiben, wenn eine vorgegebene Zeit verstrichen ist, nachdem die Verriegelungsschaltung im Haltemodus betrieben wurde.

4. Schaltersteuervorrichtung nach Anspruch 3, wobei
die Halteschaltung weiter einschließt
eine Eingangsschaltung, die konfiguriert ist, um das Umschalten der Verriegelungsschaltung in den Haltemodus zu steuern und einen Zeitgeber der Zeitgeberschaltung gemäß dem Sicherheitssignal zu starten.

5. Schaltersteuervorrichtung nach Anspruch 4, wobei
die Eingangsschaltung einschließt:
einen ersten Transistor, der konfiguriert ist, um gemäß dem Steuersignal ein- oder ausgeschaltet zu werden und im eingeschalteten Zustand einen ersten Knoten und einen zweiten Knoten elektrisch zu verbinden; und
einen zweiten Transistor, der konfiguriert ist, um gemäß dem Sicherheitssignal ein- oder ausgeschaltet zu werden und im eingeschalteten Zustand den zweiten Knoten und eine Masse elektrisch zu verbinden,
wobei die Verriegelungsschaltung das Umschalten in den Haltemodus gemäß einer Spannung des zweiten Knotens steuert und das Schaltersteuersignal gemäß einer Spannung des ersten Knotens im Übertragungsmodus ausgibt,
wobei der erste und der zweite Transistor optional NPN-Transistoren sind.

6. Schaltersteuervorrichtung nach Anspruch 5, wobei
die Verriegelungsschaltung einschließt:
einen dritten Transistor, der konfiguriert ist, um gemäß der Spannung des ersten Knotens ein- oder ausgeschaltet zu werden und einen Ausgangsknoten, von dem das Schaltersteuersignal ausgegeben wird, im eingeschalteten Zustand elektrisch mit einem Leistungsknoten zu verbinden;
einen vierten Transistor, der konfiguriert ist, um gemäß einer Spannung eines dritten Knotens ein- oder ausgeschaltet zu werden und im eingeschalteten Zustand den ersten Knoten und die Masse elektrisch zu verbinden;
einen ersten Kondensator, der elektrisch zwischen dem Leistungsknoten und dem ersten Knoten verbunden ist;
einen ersten Widerstand, der elektrisch zwischen dem Leistungsknoten und dem ersten Knoten verbunden ist;
einen zweiten Widerstand, der elektrisch zwischen dem dritten Knoten und dem Ausgangsknoten verbunden ist; und
einen zweiten Kondensator, der elektrisch zwischen dem Ausgangsknoten und der Masse verbunden ist,
wobei eine Spannung des dritten Knotens durch die Spannung des zweiten Knotens, die Spannung des Ausgangsknotens und eine von der Zeitgeberschaltung angelegte Spannung bestimmt wird, wobei optional
der dritte Transistor ein PNP-Transistor und der vierte Transistor ein NPN-Transistor ist.

7. Schaltersteuervorrichtung nach Anspruch 6, wobei
die Verriegelungsschaltung weiter einschließt:
eine Zenerdiode, die konfiguriert ist, um eine Kathode, die elektrisch mit dem zweiten Knoten verbunden ist, und eine Anode, die elektrisch mit dem dritten Knoten verbunden ist, einzuschließen; und
einen fünften Transistor, der gemäß der Spannung des dritten Knotens ein- oder ausgeschaltet wird, und um im eingeschalteten Zustand einen Steueranschluss des zweiten Transistors elektrisch mit der Masse zu verbinden,
wobei der fünfte Transistor ein NPN-Transistor ist.

8. Schaltersteuervorrichtung nach Anspruch 6 oder Anspruch 7, wobei
die Zeitgeberschaltung einschließt:
einen sechsten Transistor, der konfiguriert ist, um gemäß einer an einen Steueranschluss des zweiten Transistors angelegten Spannung ein- oder ausgeschaltet zu werden und im eingeschalteten Zustand einen vierten Knoten und die Masse elektrisch zu verbinden;
einen dritten Widerstand, der zwischen dem Leistungsknoten und dem vierten Knoten verbunden ist;
einen dritten Kondensator, der zwischen dem vierten Knoten und der Masse verbunden ist; und
einen siebten Transistor, der konfiguriert ist, um gemäß einer Spannung des vierten Knotens ein- oder ausgeschaltet zu werden und im eingeschalteten Zustand den dritten Knoten und die Masse elektrisch zu verbinden, wobei optional
der sechste Transistor ein NPN-Transistor ist und der siebte Transistor ein Metalloxid-Halbleiter-Feldeffekttransistor (P-Kanal-MOSFET) ist.

9. Schaltersteuervorrichtung nach einem vorstehenden Anspruch, wobei
die Haltesteuerschaltung einschließt
eine Ausschaltschaltung, die konfiguriert ist, um ein Zeitgeber-Ausschaltsignal an die Zeitgeberschaltung auszugeben, um einen Zeitgeberbetrieb der Zeitgeberschaltung im ausgeschalteten Zustand zu halten, wenn das Deaktivierungssignal eingegeben wird.

10. Schaltersteuervorrichtung nach Anspruch 9, wenn sie von einem der Ansprüche 6 bis 8 abhängig ist, wobei
die Ausschaltschaltung einschließt:
einen achten Transistor, der konfiguriert ist, um gemäß einer Spannung eines fünften Knotens ein- oder ausgeschaltet zu werden und im eingeschalteten Zustand den Leistungsknoten und einen sechsten Knoten elektrisch zu verbinden;
einen neunten Transistor, der gemäß einer Spannung des sechsten Knotens ein- oder ausgeschaltet wird und um im eingeschalteten Zustand den fünften Knoten und die Masse elektrisch zu verbinden;
einen vierten Kondensator, der elektrisch zwischen dem sechsten Knotenpunkt und der Masse verbunden ist;
einen vierten Widerstand, der elektrisch zwischen dem Leistungsknoten und einem Steueranschluss des achten Transistors verbunden ist;
einen fünften Widerstand, der elektrisch zwischen dem sechsten Knoten und einem Steueranschluss des neunten Transistors verbunden ist; und
eine Diode, die konfiguriert ist, um eine Anode, an die das Deaktivierungssignal angelegt wird, und eine mit dem sechsten Knoten verbundene Kathode einzuschließen,
wobei das Zeitgeber-Aus-Signal an den sechsten Knoten ausgegeben wird, wenn der achte und der neunte Transistor eingeschaltet sind.

11. Schaltersteuervorrichtung nach Anspruch 10, wobei
der achte Transistor ein PNP-Transistor ist und der neunte Transistor ein NPN-Transistor ist.

12. Schaltersteuervorrichtung nach Anspruch 11, wobei
die Zeitgeberschaltung weiter einschließt:
eine zweite Diode, die konfiguriert ist, um eine Anode, die elektrisch mit dem vierten Knoten verbunden ist, und eine Kathode, die elektrisch mit einem Steueranschluss des siebten Transistors verbunden ist, einzuschließen; und
eine dritte Diode, die konfiguriert ist, um eine Anode, die elektrisch mit dem sechsten Knoten verbunden ist, und eine Kathode, die elektrisch mit dem Steueranschluss des siebten Transistors verbunden ist, einzuschließen.

13. Schaltersteuervorrichtung nach einem der Ansprüche 10 bis 12, wobei
die Haltesteuerschaltung weiter einschließt
eine Freigabeschaltung, die konfiguriert ist, um eine Ausgabe des Zeitgeber-Aus-Signals der Ausschaltschaltung freizugeben, wenn das Rücksetzsignal eingegeben wird.

14. Schaltersteuervorrichtung nach Anspruch 13, wobei
die Freigabeschaltung einschließt
einen zehnten Transistor, der konfiguriert ist, um gemäß dem Rücksetzsignal ein- oder ausgeschaltet zu werden und im eingeschalteten Zustand den zweiten Knoten und die Masse elektrisch zu verbinden, und
wobei der zehnte Transistor ein NPN-Transistor ist.

15. Batteriepack (10), umfassend:
ein Batteriemodul (300), das konfiguriert ist, um eine Vielzahl von Zellen einzuschließen, die in Reihe oder parallel zueinander geschaltet sind;
einen Schalter (220), der konfiguriert ist, um die elektrische Verbindung zwischen dem Batteriemodul und einer Last (20) zu steuern;
einen Treiber (210), der konfiguriert ist, um das Öffnen und Schließen des Schalters zu steuern; und die Schaltersteuervorrichtung (100) nach einem der Ansprüche 1 bis 14, wobei der Treiber das Öffnen und Schließen des Schalters gemäß einem von der Schaltersteuervorrichtung ausgegebenen Schaltersteuersignal steuert.

## Revendications

1. Dispositif de commande d'interrupteur (100) pour l'ouverture et la fermeture d'un interrupteur afin de commander la connexion électrique entre un module de batterie et une charge, le dispositif de commande d'interrupteur comprenant :
un premier dispositif de commande (110) ;
un circuit de rétention (130) configuré pour recevoir un signal de commande (CS) et un signal de sécurité (SS) et pour fonctionner en deux modes, lesdits deux modes comprenant :
lorsque le signal de sécurité indique un état normal du premier dispositif de commande, un mode de transfert pour la sortie d'un signal de commande d'interrupteur dont le niveau est modifié en fonction du signal de commande ; et
lorsque le signal de sécurité indique un état anormal du premier dispositif de commande, un mode de rétention pour conserver le signal de commande de l'interrupteur dans un état précédent pendant une durée prédéterminée,
un circuit de commande de rétention (140) configuré pour interdire le fonctionnement du circuit de rétention dans le mode de rétention lorsqu'un signal de désactivation (DS) est reçu ;
le premier dispositif de commande étant configuré pour surveiller l'état d'un dispositif dans lequel le dispositif de commande d'interrupteur est monté et
émettre le signal de commande pour commander l'interrupteur et émettre le signal de désactivation en fonction de l'état de fonctionnement du dispositif dans lequel le dispositif de commande de l'interrupteur est monté ;
un deuxième dispositif de commande (120) configuré pour émettre le signal de sécurité en fonction de l'état de fonctionnement du premier dispositif de commande,
dans lequel le circuit de rétention fonctionne en mode de transfert indépendamment du signal de sécurité tandis que le fonctionnement en mode de rétention est interdit par le circuit de commande de rétention.

2. Dispositif de commande d'interrupteur selon la revendication 1, dans lequel
le circuit de commande de rétention permet au circuit de rétention de fonctionner en mode de rétention lorsqu'un signal de réinitialisation est reçu, et
le premier dispositif de commande émet le signal de réinitialisation en fonction de l'état de fonctionnement du dispositif.

3. Dispositif de commande d'interrupteur selon la revendication 1 ou la revendication 2, dans lequel
le circuit de rétention inclut :
un circuit de verrouillage configuré pour fonctionner soit en mode de transfert, soit en mode de rétention, et pour émettre le signal de commande de l'interrupteur en fonction du résultat du produit logique du signal de commande et du signal de sécurité en mode de transfert, et pour maintenir le signal de commande de l'interrupteur dans un état précédent en mode de rétention ; et
un circuit de temporisation configuré pour actionner le circuit de verrouillage en mode de transfert lorsqu'un délai prédéterminé s'écoule après le fonctionnement du circuit de verrouillage en mode de rétention.

4. Dispositif de commande d'interrupteur selon la revendication 3, dans lequel
le circuit de rétention inclut en outre
un circuit d'entrée configuré pour commander la commutation du circuit de verrouillage en mode de rétention et le démarrage d'une minuterie du circuit de minuterie en fonction du signal de sécurité.

5. Dispositif de commande d'interrupteur selon la revendication 4, dans lequel
le circuit d'entrée inclut :
un premier transistor configuré pour être activé ou désactivé en fonction du signal de commande et pour connecter électriquement un premier nœud et un deuxième nœud lorsqu'il est activé ; et
un deuxième transistor configuré pour être activé ou désactivé en fonction du signal de sécurité et pour connecter électriquement le deuxième nœud et une masse lorsqu'il est activé,
dans lequel le circuit de verrouillage commande le passage en mode de rétention en fonction d'une tension du deuxième nœud, et émet le signal de commande d'interrupteur en fonction d'une tension du premier nœud en mode de transfert,
dans lequel, éventuellement, les premier et deuxième transistors sont des transistors NPN.

6. Dispositif de commande d'interrupteur selon la revendication 5, dans lequel
le circuit de verrouillage inclut :
un troisième transistor configuré pour être allumé ou éteint en fonction de la tension du premier nœud et pour connecter électriquement un nœud de sortie à partir duquel le signal de commande de l'interrupteur est émis et un nœud d'alimentation lorsqu'il est allumé ;
un quatrième transistor configuré pour être allumé ou éteint en fonction de la tension d'un troisième nœud et pour connecter électriquement le premier nœud et la masse lorsqu'il est allumé ;
un premier condensateur connecté électriquement entre le nœud de puissance et le premier nœud ;
une première résistance connectée électriquement entre le nœud de puissance et le premier nœud ;
une deuxième résistance connectée électriquement entre le troisième nœud et le nœud de sortie ; et
un deuxième condensateur connecté électriquement entre le nœud de sortie et la masse,
dans lequel une tension du troisième nœud est déterminée par la tension du deuxième nœud, la tension du nœud de sortie et une tension appliquée par le circuit de minuterie, dans lequel, en option,
le troisième transistor est un transistor PNP, et le quatrième transistor est un transistor NPN.

7. Dispositif de commande d'interrupteur selon la revendication 6, dans lequel
le circuit de verrouillage inclut en outre :
une diode Zener configurée de manière à inclure une cathode connectée électriquement au deuxième nœud et une anode connectée électriquement au troisième nœud ; et
un cinquième transistor qui est activé ou désactivé en fonction de la tension du troisième nœud, et qui relie électriquement une borne de commande du deuxième transistor et la masse lorsqu'il est activé,
dans lequel le cinquième transistor est un transistor NPN.

8. Dispositif de commande d'interrupteur selon la revendication 6 ou la revendication 7, dans lequel
le circuit de minuterie inclut :
un sixième transistor configuré pour être allumé ou éteint en fonction d'une tension appliquée à une borne de commande du deuxième transistor et pour connecter électriquement un quatrième nœud et la masse lorsqu'il est allumé ;
une troisième résistance connectée entre le nœud de puissance et le quatrième nœud ;
un troisième condensateur connecté entre le quatrième nœud et la masse ; et
un septième transistor configuré pour être activé ou désactivé en fonction d'une tension du quatrième nœud et pour connecter électriquement le troisième nœud et la masse lorsqu'il est activé, dans lequel, en option,
le sixième transistor est un transistor NPN, et le septième transistor est un transistor à effet de champ métal-oxyde-semiconducteur (MOSFET à canal P).

9. Dispositif de commande d'interrupteur selon une quelconque revendication précédente, dans lequel
le circuit de commande de rétention inclut
un circuit d'arrêt configuré pour envoyer un signal d'arrêt de minuterie au circuit de minuterie afin de maintenir le fonctionnement de la minuterie dans un état d'arrêt lorsque le signal de désactivation est entré.

10. Dispositif de commande d'interrupteur selon la revendication 9, lorsqu'elle dépend de l'une des revendications 6 à 8, dans lequel
le circuit hors tension inclut :
un huitième transistor configuré pour être allumé ou éteint en fonction d'une tension d'un cinquième nœud et pour connecter électriquement le nœud d'alimentation et un sixième nœud lorsqu'il est allumé ;
un neuvième transistor qui est activé ou désactivé en fonction d'une tension du sixième nœud et qui assure la connexion électrique entre le cinquième nœud et la masse lorsqu'il est activé ;
un quatrième condensateur connecté électriquement entre le sixième nœud et la masse ;
une quatrième résistance connectée électriquement entre le nœud de puissance et une borne de commande du huitième transistor ;
une cinquième résistance connectée électriquement entre le sixième nœud et une borne de commande du neuvième transistor ; et
une diode configurée pour inclure une anode sur laquelle est injecté le signal de désactivation et une cathode connectée au sixième nœud,
dans lequel le signal d'arrêt de la minuterie est envoyé au sixième nœud lorsque le huitième transistor et le neuvième transistor sont activés.

11. Dispositif de commande d'interrupteur selon la revendication 10, dans lequel
le huitième transistor est un transistor PNP, et le neuvième transistor est un transistor NPN.

12. Dispositif de commande d'interrupteur selon la revendication 11, dans lequel
le circuit de minuterie inclut en outre :
une deuxième diode configurée de manière à inclure une anode connectée électriquement au quatrième nœud et une cathode connectée électriquement à une borne de commande du septième transistor ; et
une troisième diode configurée pour inclure une anode connectée électriquement au sixième nœud et une cathode connectée électriquement à la borne de commande du septième transistor.

13. Dispositif selon l'une quelconque des revendications 10 à 12, dans lequel :
le circuit de commande de rétention inclut en outre
un circuit de déclenchement configuré pour libérer une sortie du signal d'arrêt du minuteur du circuit d'arrêt lorsque le signal de réinitialisation est injecté.

14. Dispositif de commande d'interrupteur selon la revendication 13, dans lequel
le circuit de déclenchement inclut
un dixième transistor configuré pour être activé ou désactivé en fonction du signal de réinitialisation et pour connecter électriquement le deuxième nœud et la masse lorsqu'il est activé, et
dans lequel le dixième transistor est un transistor NPN.

15. Bloc-batterie (10) comprenant :
un module de batterie (300) configuré pour inclure une pluralité de cellules connectées en série ou en parallèle les unes aux autres ;
un interrupteur (220) configuré pour commander la connexion électrique entre le module de batterie et une charge (20) ;
un pilote (210) configuré pour commander l'ouverture et la fermeture de l'interrupteur ; et le dispositif de commande d'interrupteur (100) selon l'une quelconque des revendications 1 à 14, dans lequel le pilote commande l'ouverture et la fermeture de l'interrupteur selon un signal de commande d'interrupteur émis par le dispositif de commande d'interrupteur.
